# EUROPEAN PATENT SPECIFICATION

(11) **EP 3 533 760 B1**
(45) Date of publication and mention of the grant of the patent: **16.07.2025**
(21) Application number: 17864976.0
(22) Date of filing: 17.10.2017
(51) Int. Cl.: C01B 33/18, B24B 37/00, C03B 8/04, C03B 20/00, C09K 3/14, H01L 21/304, C09G 1/02

(54) **FUMED SILICA AND PRODUCTION METHOD THEREFOR**
PYROGENES SILICIUMOXID UND HERSTELLUNGSVERFAHREN DAFÜR
SILICE PYROGÉNÉE ET SA MÉTHODE DE PRODUCTION

(30) Priority: 28.10.2016 JP 2016211229
(43) Date of publication of application: 04.09.2019
(73) Proprietor: Tokuyama Corporation, Shunan-shi, Yamaguchi 745-8648 (JP)
(72) Inventor: UEDA Masahide, Shunan-shi Yamaguchi 745-8648 (JP); TAKATA Yukihiro, Shunan-shi Yamaguchi 745-8648 (JP); HORITSUNE Junya, Shunan-shi Yamaguchi 745-8648 (JP)
(74) Representative: Germain Maureau
(86) International application number: PCT/JP2017/037482
(87) International publication number: WO 2018/079334

(56) References cited:
- WO-A1-2015/012118
- JP-A- 2008 019 157
- JP-A- 2010 158 747
- JP-A- 2014 214 042
- US-A1- 2006 030 243
- US-A1- 2016 177 155

## Description

### TECHNICAL FIELD

The present disclosure relates to fumed silica and a method for producing the same, particularly to fumed silica for chemical mechanical polishing that can reduce scratches, and a method for producing the same.

### BACKGROUND ART

The degree of integration of semiconductor devices has been increasing year by year, requiring much more miniaturization and multi-layering of interconnects. Accordingly, also in a process of producing semiconductor devices, quality required of layer surfaces has been increasing. The allowable number of scratches on the surface per unit area is reduced, and the allowable size and depth of the scratches are getting smaller and smaller.

In order to meet these requirements, chemical mechanical polishing (may be hereinafter abbreviated as "CMP"), which is one of surface treatment techniques for semiconductors, is required to reduce contamination of a target to be polished, reduce scratches, and have high polishing efficiency and a high selection ratio for a target to be polished, for example.

Commonly, silica, cerium oxide, or any other substance is used as polishing particles for the CMP. For example, fumed silica, which has been commonly used in the art, has high purity and high polishing efficiency. However, use of fumed silica in the CMP results in many scratches formed on the target due to the influence of chemical components. In contrast, colloidal silica can reduce the scratches, but is lower in polishing efficiency than fumed silica, and is disadvantageous in terms of purity. Further, cerium oxide, which has been known to have high polishing efficiency, causes many scratches on the target due to its poor dispersion stability, and thus, is also disadvantageous in terms of purity.

Fumed silica contains primary particles which are strongly aggregated by fusion, for example, to form secondary particles, and the secondary particles are loosely aggregated to form tertiary particles. Thus, fumed silica usually exists as the tertiary particles when it is in the form of powder. When strongly dispersed in water, fumed silica is dispersed into the size of the secondary particles, but is not dispersed into the size of the primary particles. Thus, it is assumed that CMP is performed with fumed silica in the form of the secondary particles, and that the scratches are less likely to be formed if the secondary particles are kept from increasing in size (Yoshio Mitani, et al. "Formation and characteristics of fumed silica - Applicability of produced particles for CMP from the viewpoint of flame analysis -", Proceedings of Academic Lecture Meeting at 2008 Autumn Conference of the Japan Society for Precision Engineering, pp. 857-858).

Japanese Unexamined Patent Publication No. 2006-136996 describes a polishing liquid composition used for reducing the scratches. The polishing liquid composition is filtrated with a filter to reduce the amount of polishing particles having a particle diameter equal to or larger than 0.56 µm and smaller than 1 µm and the amount of polishing particles having a particle diameter equal to or larger than 3 µm to a certain level or smaller. Specifically, the particle diameters of the polishing particles in the polishing liquid composition using colloidal silica slurry are measured by a number counting method (Single Particle Optical Sizing Method), in particular, by using AccuSizer 780APS manufactured by Particle Sizing Systems.

Japanese Translation of PCT Application No. 2010-510151 describes fumed silica having a density of 200 g/l to 2,500 g/l, containing coarse particles, which are defined as sintered coarse particles having a particle diameter of 0.5 µm to 500 µm, in a ratio less than 0.03 wt%, and containing less than 100,000 coarse particles in 1 ml of 10 wt% aqueous dispersion. Japanese Translation of PCT Application No. 2010-510151 also describes that a silica dispersion liquid is prepared by dispersing silica in a disperse medium such as water at a rotation speed of 25,000 rpm or more for five minutes or more, for example, with a rotorstator disperser, stabilizing the dispersion liquid at alkaline pH of 9.9 to 10.2, and then removing fine fumed silica. Then, the coarse particles having a diameter of 0.5 µm to 500 µm in the silica dispersion liquid are counted by a light obscuration method such as white light or laser light, more specifically, with AccuSizer 680 or 780, Liquilaz manufactured by PSM, or FAS manufactured by Topas GmbH.

However, even when these methods are used, no correlation has been found sometimes between the count of particles of 0.56 µm or larger and the influence thereof on the scratches, and thus, problems remain unsolved as to the use of these methods for evaluation of coarse secondary particles having an influence on the scratches. Specifically, for the polishing, slurry is used in the order of 100 ml, and in the order of 10 g in terms of silica. By contrast, according to the method of evaluating the coarse particles described in the above-described Patent Documents, slurry is used for the quantitative measurement in the order of 1 µl, and in the sub-milligram order in terms of silica. Furthermore, samples used for the measurement are not silica powders the whole amounts of which are exactly measured, but are extracted from silica slurry in which silica is considered to be present more unevenly. For these reasons, it is assumed that problems might remain in the accuracy of the amount of coarse particles evaluated.
US 2006/0030243 A1 discloses a polishing composition containing an abrasive and water, wherein the polishing composition has a pH from 0.1 to 7, and satisfies the following conditions:
1) the number of polishing particles having size of 0.56 µm or more and less than 1 µm is 500,000 or less per 1 cm³ of the polishing composition, and
2) the ratio of polishing particles having sizes of 1 µm or more is 0,001% by weight or less to the entire polishing particles in the polishing composition.
US 2016/177155 A1 discloses a silica for CMP which satisfies the following (A) to (C) :
A) a BET specific surface area of 40 m²/g or more and 180 m²/g or less;
B) a particle density measure by He-gas pycnometer method of 2.24 g/cm³ or more;
C) a coefficient of variation in primary particle diameter calculated by TEM/image analysis of 0.40 or less. (See §[0013] to §[0016])
The silica for CMP includes fumed silica produced by a flame hydrolysis reaction of a silane compound.

### SUMMARY

It is an object of the present disclosure to provide fumed silica for CMP that can significantly reduce scratches that are formed after polishing on a surface of a target to be polished, the surface being important for miniaturization and multi-layering.

As a result of extensive investigations to solve the above-described problems, the inventors of the present disclosure have found that, when fumed silica is used as polishing particles for CMP, the residual amount of the fumed silica on a sieve when the fumed silica is subjected to wet sieving using an electroformed sieve having a perforation size of 5 µm ("the residual amount on a sieve when fumed silica is subjected to wet sieving using an electroformed sieve having a perforation size of 5 µm" may be hereinafter referred to as "the residual amount on a sieve having a perforation size of 5 µm") has a particularly important influence on the occurrence of scratches.

In the CMP, in general, polishing particles are dispersed in a polishing liquid to prepare a polishing liquid composition, and then adjustment such as removal of coarse particles with a filter as described in Japanese Unexamined Patent Publication No. 2006-136996 is performed. Nevertheless, the inventors have found that, when fumed silica is used as the polishing particles, there is a highly reproducible correlation between the residual amount on a sieve having a perforation size of 5 µm and the number of scratches per unit area, and have achieved the present disclosure.

A mechanism of how the residual amount of the fumed silica on a sieve having a perforation size of 5 µm exerts an influence on the occurrence of scratches during polishing is uncertain. However, since the presence of secondary particles of fumed silica that have increased in size plays a role in the formation of aggregates remaining on a sieve having a perforation size of 5 µm, it is assumed that reducing the residual amount on a sieve having a perforation size of 5 µm would reduce the coarse particles causing the scratches.

Specifically, the present disclosure is directed to fumed silica. The fumed silica is produced using tetrachlorosilane by flame hydrolysis and has a BET specific surface area of 57 m²/g or larger and 400 m²/g or smaller. When a dispersion liquid, which is prepared by ultrasonically dispersing 6.25 mass% of the fumed silica in water at an oscillation frequency of 20 kHz and an amplitude of 15 µm to 25 µm for three minutes, is subjected to wet sieving using an electroformed sieve having a perforation size of 5 µm, a residual amount of the fumed silica on the sieve is 5 ppm or lower.

In one embodiment, the fumed silica of the present disclosure contains 0.3 ppm or lower of Fe, 0.3 ppm or lower of Al, 0.1 ppm or lower of Ni, 0.1 ppm or lower of Cr, 0.1 ppm or lower of Ti, and 0.1 ppm or lower of boron.

The fumed silica of the present disclosure is suitably used for CMP.

The fumed silica of the present disclosure can be suitably used for CMP. Use of the fumed silica as polishing abrasive grains for polishing semiconductor wafers or devices can reduce contamination by impurities, improve polishing efficiency, and significantly reduce the occurrence of scratches during polishing.

### DETAILED DESCRIPTION

Fumed silica according to the invention refers to general silica powder that is obtained through a flame hydrolysis reaction of a silane compound, i.e. tetrachlorosilane, by a production method in which the silane compound is hydrolyzed in flame formed by flammable gas such as hydrogen gas and oxygen-containing gas such as air. Note that fumed silica is generally produced by performing flame hydrolysis on a silicon chloride such as chlorosilane as described in Japanese Examined Patent Publication No. S47-46274.

The fumed silica of the present embodiment has a BET specific surface area of 57 m²/g or larger and 400m²/g or smaller. In a preferred embodiment, the BET specific surface area is 60 m²/g or larger and 400 m² or smaller. In a more preferable embodiment, the BET specific surface area 60 m²/g or larger and 160 m²/g or smaller. In an even more preferable embodiment, the BET specific surface area is 60 m²/g or larger and 90 m²/g or smaller. If the BET specific surface area is smaller than the lower limits of the above-described ranges, more scratches are formed during CMP using the fumed silica. In this context, the scratches are scratch marks caused by polishing. If the BET specific surface area exceeds the upper limits of the above-described ranges, polishing speed significantly decreases, which significantly impairs the production efficiency of semiconductor devices.

One of the most important features of the fumed silica of the present embodiment is that the residual amount thereof on a sieve having a perforation size of 5 µm is particularly low. Specifically, when a dispersion liquid, which is prepared by ultrasonically dispersing 6.25 mass% of the fumed silica in water (at an oscillation frequency of 20 kHz and an amplitude of 15 µm to 25 µm for three minutes), is subjected to wet sieving method with an electroformed sieve having a perforation size of 5 µm, the residual amount of the fumed silica on the sieve is 5 ppm or lower. The residual amount on the sieve is preferably 3 ppm or lower, more preferably 1 ppm or lower.

As described above, primary particles of the fumed silica formed through a reaction in flame are strongly aggregated by fusion or the like to form secondary particles, and the secondary particles are loosely aggregated to form tertiary particles. The fumed silica in the form of powder usually exists as the tertiary particles. However, when the fumed silica is strongly dispersed in water (when the degree of dispersion is increased), the fumed silica is dispersed into the size of the secondary particles. Abrasive grains for CMP are considered to be in the form of the secondary particles. As described above, in the CMP, it is common that polishing particles are dispersed in a polishing liquid to form a polishing liquid composition, and coarse particles are removed with a filter. Nevertheless, it has been found that, when the fumed silica is used as the polishing particles, there is a high reproducible correlation between the residual amount on a sieve having a perforation size of 5 µm and the number of scratches per unit area.

A mechanism of how the residual amount on a sieve having a perforation size of 5 µm exerts an influence on the occurrence of scratches during polishing is uncertain. However, the wet sieving using the electroformed sieve makes it possible to quantitatively measure the residual amount on a sieve having a perforation size of 5 µm, which is assumed to have a correlation with secondary particles that have increased in size. Thus, setting the residual amount on the sieve having a perforation size of 5 µm within the above-described ranges can significantly reduce the occurrence of scratches during polishing.

It is important that the quantitative measurement of the residual amount on the sieve having a perforation size of 5 µm is performed by the wet sieving using the electroformed sieve. Use of this method can sufficiently increase the amount of silica used for tests. Specifically, the amount of a sample thereof can be of the order of 10 g, and by extension, the whole amount of the sample can be subjected to the measurement.

Specifically, the residual amount on the sieve corresponds to a value obtained when fumed silica in an amount of 20 g or more as the sample amount is sieved. For this sieving, the 6.25 mass% ultrasonic dispersion liquid can be prepared at once, or can be prepared separately. For example, to 20 g of fumed silica measured and put in a vessel together with 300 g of water, ultrasonic waves may be applied at an oscillation frequency of 20 kHz and an amplitude of 15 µm to 25 µm for three minutes. Alternatively, as will be described later, to 5 g of fumed silica and 75 g of water in each of four vessels, ultrasonic waves may be applied at an oscillation frequency of 20 kHz and an amplitude of 15 µm to 25 µm for three minutes.

In preparing the ultrasonic dispersion liquid to which 6.25 mass% of fumed silica is added, any ultrasonic treatment apparatus may be used without particular limitations as long as it can perform ultrasonic dispersion treatment at an oscillation frequency of 20kHz and an amplitude of 15 µm to 25 µm for three minutes. For example, when an ultrasonic homogenizer (US-600T) manufactured by NIHONSEIKI KAISHA LTD. is used, the oscillation frequency is 20 kHz, and an output scale of 6 corresponds to an amplitude of 22.5 µm.

The temperature of the dispersion liquid to which ultrasonic waves are applied is set to 20°C to 30°C.

As an alternative, a particle size distribution measurement method based on the laser diffraction/scattering method may be used. However, as described in Japanese Unexamined Patent Publication No. 2008-19157, the detection level of this method is in the order of percent and the detection sensitivity is low, and this method is not suitable for the quantitative measurement of a trace amount of particles having a size exceeding 5 µm among fine silica particles as in the present embodiment, for example. Note that in this measurement method, a silica dispersion liquid is used for the measurement, and the amount of silica used for the measurement is small.

The fumed silica of the present embodiment preferably contains 0.3 ppm or lower of Fe, more preferably 0.1 ppm or lower of Fe. A mechanism of how the Fe content exerts an influence on the occurrence of scratches during polishing is uncertain. However, in general, the scratches increases with the increase in the Fe content, and the Fe content within the above-described range makes it possible to significantly reduce the occurrence of scratches during polishing. Fe is generally derived from the raw material, but can be mixed in the form of wear debris of a reaction vessel or a pipe.

Furthermore, the fumed silica of the present embodiment preferably contains 0.3 ppm or lower of Al, 0.1 ppm or lower of Ni, 0.1 ppm or lower of Cr, 0.1 ppm or lower of Ti, and 0.1 ppm or lower of boron. The fumed silica in which impurities are significantly reduced in this manner is suitable because it can be satisfactorily used for applications requiring use of polishing abrasive grains of high purity, such as a CMP process for semiconductor devices.

In fumed silica that is produced by hydrolyzing a silane compound in flame, boron among the above-described impurities is usually derived from the raw material, and some of Al, Ni, Cr, and Ti are not only derived from raw materials, but are also derived from wear debris of a reaction vessel, pipes, and the like. If the amount of these impurities increases, a target surface to be polished is more susceptible to contamination during polishing. A target surface thus contaminated is not suitable because it causes deterioration of electric characteristics of a substrate, for example, depending on material or application of the target to be polished.

The fumed silica of the present embodiment can be suitably used as fumed silica for CMP because the residual amount thereof on a sieve having a perforation size of 5 µm is significantly low, and the scratches are less formed as described above. In particular, in a CMP process for semiconductor devices, the fumed silica is suitably used for CMP of a metal film as a conductor, CMP for polysilicon as a semiconductor, or CMP for a silicon oxide film (insulating film) as a nonconductor, for example.

The fumed silica of the present embodiment may be used appropriately after known surface treatment is performed with a known surface treatment agent. The fumed silica whose surface has been treated can be used for various applications, for example, for fillers, thickeners, and plasticizers for various resins, and external additives for toner used in electrophotography.

A method for producing the fumed silica of the present embodiment is not particularly limited, and any production method for fine silica particles may be used as long as the produced fine silica particles has a BET specific surface area of 57 m²/g or larger and 400 m²/g or smaller, and has the residual amount on the sieve of 5 ppm or lower when subjected to the wet sieving using an electroformed sieve having a perforation size of 5 µm. Specifically, examples thereof include a method of feeding a silane compound into a reactor and burning or hydrolyzing it in flame. For example, methods described in Japanese Examined Patent Publication No. S47-46274, Japanese Examined Patent Publication No. S58-54085, Japanese Unexamined Patent Publication No. S59-169922, Japanese Unexamined Patent Publication No. S59-184721, and Japanese Unexamined Patent Publication No. S60-011218 can be referred to.

Fumed silica is formed in a reaction step of feeding a raw-material gas containing a silane compound into flame, and burning or hydrolyzing the silane compound in the flame. The fumed silica formed in the reaction step is cooled in a cooling step, and is then sent to a separation and collection step, in which a solid content is separated from a reactant gas to be collected, and is then deacidified in a deacidification step.

The fumed silica thus obtained is powder having a bulk density as low as about 0.023 g/cm³. Such fumed silica, if packed as it is, increases the packing and shipping costs, and is not easy to handle due to its fluffiness. Thus, the fumed silica is usually sent to a compression step to increase the bulk density before a packing step.

As will be described in detail later, a classification step of classifying and removing, under dry conditions, secondary particles that have increased in size is performed after the cooling step and before the compression step. This classification step makes it possible to significantly reduce the residual amount on a sieve having a perforation size of 5 µm. The embodiment will be described below in detail.

### (Reaction Step)

The reaction step of the present embodiment is a step of feeding silane gas as a raw material into a reactor and hydrolyzing the silane gas in flame to form fumed silica. The silane gas is heated and vaporized by a raw material vaporizer, and is premixed with flammable gas such as hydrogen or hydrogen-containing gas, and combustion-supporting gas such as oxygen or air, and if necessary, nonflammable gas such as nitrogen or argon. In a preferred embodiment, the reactor for combustion or hydrolyzing this premixed gas in flame is a closed system in which the atmosphere in the reactor is completely blocked from the air from the viewpoint of easily maintaining the pressure in the reactor and keeping contaminants from entering the reactor. Specifically, a burner is disposed in the reactor, and gas that is fed to the burner and the reactor, gas that is discharged from the reactor, and the fumed silica flow through a pipe.

The pressure in the reactor is not particularly limited. However, as the pressure increases, the flame length becomes shorter and the temperature distribution in flame decreases, and consequently, fumed silica whose primary particles have more uniform diameters, that is, have smaller coefficient of variation, can be obtained. The pressure in the reactor can be easily measured using a pressure meter set at any position (except for a position near an outlet of the reactor through which the gas is discharged from the reactor). The pressure near the outlet of the reactor is more likely to fluctuate due to the flow rate of the discharged gas, for example. In consideration of adhesion of the fumed silica thus produced, the pressure meter is usually set on a surface of the reactor on which the burner is disposed, or on a wall surface thereof on an upstream side of a gas flow flowing from the burner to the outlet of the reactor to measure the pressure.

A method of adjusting the pressure in the reactor is not particularly limited. However, the pressure can be adjusted by controlling the volume of gas to be introduced into the reactor and applying pressure loss at the outlet of the reactor or in a downstream process. In general, the pressure in the reactor is preferably set to 1 MPaG or lower in view of the pressure resistance of the apparatus and the upper limit of pressure of a raw material feed pump, for example.

The adiabatic flame temperature during reaction is not particular limited, but is commonly set to 1500°C or higher and 2300°C or lower.

In the reactor, flame is usually formed by the burner. As the burner, a multi-tube burner having a concentric cross-section is preferably used from the viewpoint of ease of ignition and stability of burning, for example. The multi-tube burner includes a center tube and a plurality of annular tubes spreading concentrically from the center tube. A double tube, a triple tube, or a quadruple tube is generally used, among which the triple tube is particularly preferred. As these multi-tube burners, those having a center tube diameter of about 5 mm to 150 mm are generally used.

For forming the flame with such a multi-tube burner, flammable gas and oxygen-containing gas may be fed to the center tube and the annular tubes separately, or as a mixed gas with a mixing ratio being changed, so as to achieve a desired combustion ratio for obtaining the above-described adiabatic flame temperature at a combustion port of the burner. Specifically, in the case of a triple tube in which a center tube, a first annular tube, and a second annular tube are arranged in this order toward the outside in a radial direction of the center tube, it is preferable that hydrogen and the air be fed to the center tube, one or both of hydrogen and the air be fed to the first annular tube, and only the air be fed to the second annular tube.

In forming the flame with the multi-tube burner, a vaporized silane compound may also be fed to any gas feed tube of the multi-tube burner so as to cause the burning reaction or the hydrolysis reaction to proceed in the flame. It is particularly preferable to feed the silane compound to the center tube because the silane compound is fed to a base portion of the flame, and the burning reaction or the hydrolysis reaction proceeds stably.

The silane compound as the raw material of fumed silica is tetrachlorosilane.

As described above, the silica for CMP of the present embodiment preferably contains 0.3 ppm or lower of Fe. In order to obtain the fumed silica containing 0.3 ppm or lower of Fe, raw-material gas with reduced Fe content is preferably fed to the burner. For example, when tetrachlorosilane is used as the raw-material gas, the Fe content in this raw-material gas is preferably 0.12 ppm or lower.

Similarly, the silane compound preferably has the contents of other impurities than Fe, i.e., Al, Ni, Cr, Ti, and boron, controlled to be suitable for the fumed silica of the present embodiment. When tetrachlorosilane is used as the raw-material gas, the raw-material gas preferably contains, as the impurities, 0.12 ppm or lower of Al, 0.04 ppm or lower of Ni, 0.04 ppm or lower of Cr, and 0.04 ppm or lower of boron.

In the production method for the fumed silica of the present embodiment, the combustion or hydrolysis of the silane compound in the flame may be performed by, for example, when a triple tube burner having a center tube diameter of 50 mm is used, feeding the silane compound at 1.1 to 4.2 kmol/h, hydrogen at 75 to 200 Nm³/h, and the air at 25 to 500 Nm³/h to the center tube, feeding hydrogen at 10 to 40 Nm³/h and air at 10 to 50 Nm³/h to the first annular tube, and feeding the air at 25 to 75 Nm³/h to the second annular tube.

In the production method of the present embodiment, a reaction condition is preferably set such that the BET specific surface area of the resulting fumed silica is 57 m²/g or larger and 400 m²/g or smaller. To provide the fumed silica with a desired BET specific surface area, conditions such as the above-described adiabatic flame temperature, the pressure in the reactor, the ratio between oxygen (air) and hydrogen to be fed to the burner, and the feed rate of the raw material can be adjusted.

### (Cooling Step)

The fumed silica that has been formed and grown in the reaction flame is rapidly cooled to a temperature equal to or higher than the dew-point of water or another reactant that easily condenses such that sintering, fusion, or surface changes do not occur, and is sent to the separation and collection step.

How this cooling is performed is not particularly limited, and a known method such as spraying in additional gas such as nitrogen, or cooling with a heat exchanger can be used, for example.

### (Classification Step)

In a high-temperature portion in the reaction step and the cooling step, secondary particles are formed by strong aggregation such as fusion, and it is assumed that the residual amount on a sieve having a perforation size of 5 µm increases when the secondary particles increase in size due to this aggregation. As described above, the classification step of classifying and removing, under dry conditions, secondary particles that have been formed and increased in size in the reaction step and/or the cooling step is performed. This step makes it possible to effectively remove particles remaining on an electroformed sieve having a perforation size of 5 µm by wet sieving (hereinafter, may also be called "particles remaining on the sieve").

The classification step is preferably performed after the cooling step and before the compression step which will be described later. More preferably, the classification step is performed after the separation and collection step, which will be described later, and before the compression step. If a deacidification step to be described later is performed, it is more preferred that the classification step be performed after the deacidification step and before the compression step because a classification apparatus is less likely to be affected by acid and thus can be easily designed.

If the classification step is performed after the cooling step, that is, after the secondary particles are formed, the particles remaining on the sieve can be effectively reduced. However, performing the classification before the separation and collection step is not economical because a large amount of reactant gas is entrained in silica, which makes the throughput enormous, and the classification facility larger.

On the other hand, the secondary particles are aggregated to form tertiary particles in the fumed silica after the compression step in which the bulk density has been adjusted. Thus, when the secondary particles that have increased in size are attempted to be removed efficiently by dry classification, it is difficult to distinguish the secondary particles from the tertiary particles. Therefore, reducing the particles remaining on the sieve accurately as in the present embodiment is difficult.

Specifically, fumed silica before the compression step having a low bulk density is most highly dispersed in a gas phase. Classifying the fumed silica in such a state under dry conditions can accurately reduce the particles remaining on the sieve.

Means of dry classification described above is not particularly limited. Examples thereof include classifying means using a sieve, a gravitational classifier, an inertial classifier, a centrifugal classifier, a fluidized-bed classifier, a wind-power classifier, and an electrostatic classifier.

In the classification step of the present embodiment, a single classifying means may be used, or two or more classifying means may be used in combination. The combination of two or more classifying means is not particularly limited. Whether a single classifying means or two or more classifying means are used, the individual classifying means can be used repeatedly many times. Using the classifying means in combination or repeating the classifying operation many times makes it possible to accurately reduce the particles remaining on the sieve.

In the case of repeating the classification step many times, when to perform the classification step is not particularly limited as long as it is performed after the cooling step and before the compression step, and may be performed once, or separately performed several times. For example, in the case of performing the classification step twice, the first classification step may be performed after the separation and collection step, and the second classification step may be performed after the deacidification step, or the classification step may be performed twice in a row after the deacidification step.

The degree of classification may be successively adjusted by the selected classifying means and the number of classifications to be performed, for example, such that the residual amount of finally obtained fumed silica on a sieve having a perforation size of 5 µm becomes 5 ppm or lower.

### (Separation and Collection Step)

Cooled fumed silica is separated into a solid content and gas by a filter or a cyclone classifier, for example, to be collected as powder in separation and collection step. This separation and collection step aims to separate solid fumed silica from gaseous reactant gas at high yield, and therefore, is distinguished in the present application from the above-described classification step aiming to remove the secondary particles that have increased in size in the solid fumed silica.

### (Deacidification Step)

The fumed silica after the separation step is sent to the deacidification step to be deacidified, if necessary. The deacidification is needed when halogenated silane in particular is used as a silane compound that is a raw material. Specifically, when chlorosilanes are used, hydrogen chloride is produced as a byproduct of flame hydrolysis reaction. Such acid has corrosiveness, and therefore, is deacidified in the deacidification step.

A deacidification method is not particularly limited and any known method can be used, but is preferably performed under dry conditions. Specifically, the fumed silica after the separation step is put into a heated deacidification vessel of a movable-bed type or a fluidized-bed type, for example, and heated gas, which is preferably air or nitrogen, is circulated therein. It is more preferable that steam be appropriately added to the circulating gas because it increases the deacidification efficiency.

### (Compression Step)

The bulk density of the collected fumed silica is generally as low as about 0.023 g/cm³, which often makes it difficult to handle and pack the fumed silica, requiring wide space for transportation and storage, and thus is uneconomical. Thus, the compression step of increasing the bulk density is performed after the deacidification step when the deacidification step is performed, or after the separation and collection step when the deacidification step is not performed.

Since the bulk density only needs to be increased in the compression step, any powder compression method using known compressing means such as a press, a ball mill, a mixer, or any other apparatus can be employed. Even if such an apparatus is not used as the compressing means, collecting the fumed silica in a silo allows the fumed silica to be compressed by its self-weight, thereby increasing the bulk density. Thus, a step of storing the resulting powder in the silo is also included in the compression step.

As the density of powder becomes after the compression increases, the powder becomes easier to handle. However, if the bulk density is excessively increased, dispersibility deteriorates and applicable physical properties are accordingly impaired when the powder is dispersed in a solvent or a resin. In the present embodiment, the compressing means is selected and the degree of compression is appropriately adjusted so that a desired bulk density providing suitable applicable physical properties can be obtained. Note that two or more compressing means may be used in combination.

Through the compression step, the bulk density is preferably set to 0.03 to 0.1 g/cm³, more preferably 0.05 to 0.1 g/cm³.

### <Examples>

The present embodiment will be described in more detail with reference to examples. However, the present disclosure is not limited only to the examples.

Various physical properties were measured by the following methods in Examples and Comparative Examples below.
(1) Specific Surface Area Measurement: performed by a nitrogen adsorption single point BET method using an automatic specific surface area analyzer (Macsorb HM-1201) manufactured by Mountech Co., Ltd.
(2) Electroformed Sieve: Wet sieving was performed with an electroformed sieve having a perforation size of 5 µm, and the residue on the sieve was quantitatively measured. A measurement sample was prepared by adding 300 g of distilled water at 25°C to 20 g of fine fumed silica particles, and dispersing the particles using an ultrasonic homogenizer (US-600T) manufactured by NIHONSEIKI KAISHA LTD. under conditions of an output scale of 6 (corresponding to an oscillation frequency of 20 kHz and an oscillation amplitude of 22.5 µm) for three minutes as a dispersion time. Consequently, a 6.25 mass% ultrasonic dispersion liquid was obtained, and the whole amount thereof was used as the measurement sample.
(3) Measurement of Contents of Impurities: The fumed silica of each of Examples and Comparative Examples was pretreated by adding hydrogen fluoride and nitric acid, and heating the mixture. The resulting residue was used as an aqueous solution, and the content of each impurity was measured by ICP emission spectrometry. For the measurement, ICP emission spectrometer Vista-MPX manufactured by Agilent Technologies, Inc. was used. As a standard solution for ICP, ICP multi-element standard IX (for 23 elements) manufactured by Merck Ltd. was used, and an ICP standard solution manufactured by Wako Pure Chemical Corporation was used for Ti.
(4) Measurement of Content of Boron: The fumed silica of each of Examples and Comparative Examples was placed in a vessel made of a polytetrafluoroethylene resin, to which mannitol for boron quantitative measurement manufactured by Merck Ltd. was added, and then hydrofluoric acid and nitric acid were added and the resulting mixture was heated for pretreatment. The resulting residue was used as an aqueous solution, and the content of each impurity was measured by ICP emission spectrometry. For the measurement, ICP emission spectrometer Vista-MPX manufactured by Agilent Technologies, Inc. was used. As a standard solution for ICP, ICP multi-element standard IX (for 23 elements) manufactured by Merck Ltd. was used.
(5) Method of Measuring Scratch Density

### -Condition for Preparing Slurry-

Sample slurry used for the evaluation of the scratch density and the polishing rate was prepared in accordance with "2.1 Condition for preparing slurry" and the condition for preparing prototype slurry sample 2 illustrated in FIG. 1 of Yamaguchi et al., "Relationship between fumed silica slurry for CMP and scratch defect occurrence", Proceedings of 2010 Kumamoto Local Lecture Meeting of the Japan Society for Precision Engineering, pp. 1-2 (hereinafter, simply referred to as "Proceedings"). Note that in preparing this sample slurry, the fumed silica of each of Examples and Comparative Examples was used as silica. Various stirring and dispersing devices and dispersion conditions used for preparing the slurry were changed from the conditions described in the "Proceedings" as follows. Stirring was performed at 600 rpm for 5 minutes with Tornado SM-103 manufactured by AS ONE Corporation and turbine blades, and then stirring was performed at 10,000 rpm for 10 minutes with T.K. Homo Mixer MARK II (manufactured by PRIMIX Corporation). Subsequently, dispersion was performed once at 80 MPa with Nano-Mizer Mark II manufactured by Yoshida Kikai Co., Ltd. For filtration, a filter (profile II, filtration accuracy: 1 µm, material: polypropylene) manufactured by Pall Corporation was used. It should be noted that the contents of Proceedings described above are incorporated herein as part of the description of the present application.

### -Polishing Conditions-

Polishing using the slurry was performed under the conditions described in "2.2 Condition for polishing copper wafer" and illustrated in Table 1 and FIG. 2 of the Proceedings except that the sample slurry prepared by the above-described procedure was used as sample slurry to be used for CMP processing (final CMP). A polishing apparatus used herein is a table-top polishing apparatus NF-300 manufactured by Nano Factor Co., Ltd., and an object to be polished (copper wafer) is a Cu-plated Si wafer of 3 inches (thickness of Cu plating: 5 µm) manufactured by D-process Inc. As an agent (cleaning liquid) for removing grains and organic matter remaining on the surface of the copper wafer after CMP processing (final CMP), CLEAN-100 manufactured by Wako Pure Chemical Corporation was diluted 10-fold to be used.

### -Measurement of Scratch Density and Polishing Rate-

The scratch density and the polishing rate were measured on the copper wafer having a surface with a Cu-plating film polished under the above-described polishing conditions. Note that the scratch density was measured according to the procedure described in "2.3 Measurement of the number of scratches" and FIG. 3 of the Proceedings. The evaluation of scratches on the Cu-plating film has a correlation with the evaluation of scratches on a silicon oxide film (insulating film) (see Proceedings). Thus, it is assumed that the same tendency as that of the measurement results of the scratch density described later is also obtained in the case where the silicon oxide film (insulating film) is polished.

### -Criteria for Scratch Density and Polishing Rate-

### (a) Scratch Density

The allowable range of the scratch density is 40 pcs/mm² or lower, preferably 30 pcs/mm² or lower.

### (b) Polishing Rate

The allowable value of the polishing rate is 12 nm/min or higher, preferably 17 nm/min or higher.

### Examples 1 to 3

Tetrachlorosilane was used as halogenated silane, and subjected to flame hydrolysis reaction under each corresponding production condition given in Table 1 to produce fumed silica. After the separation and collection step, the resulting fumed silica was collected. The contents of impurities in the tetrachlorosilane gas were as follows: Fe: less than 0.1 ppm, Al: less than 0.1 ppm, Ni: less than 0.01 ppm, Cr: less than 0.01 ppm, Ti: less than 0.01 ppm, boron: less than 0.01 ppm.

In a quartz-glass fluidized bed having an inside diameter of 15 cm, 250 g of this fumed silica was introduced. From a lower portion of the fluidized bed, air preheated to a temperature substantially the same as that of the fumed silica was introduced at 5 Nm³/h for 30 minutes. Subsequently, 225 g out of the introduced silica was extracted from an upper portion of a tube to be classified. The fumed silica after the classification was subjected to the deacidification step, and was collected again. Fumed silica collected from the deacidification step, 225 g, was introduced into the fluidized bed again, was fluidized under the above-described conditions, and then 203 g was extracted from the upper portion of the tube to be classified. The fumed silica obtained after the classification was compressed by a deaeration press to adjust the bulk density to 0.05 g/cm³, whereby fumed silica powder was obtained. Table 1 collectively shows the specific surface area, the contents of impurities, the residual amount on a sieve measured by wet sieving using an electroformed sieve having a perforation size of 5 µm, the scratch density, and the polishing rate of the obtained fumed silica powder.

### Example 4

The same tetrachlorosilane as that used in Example 1 was used as halogenated silane, and subjected to flame hydrolysis reaction under the corresponding production condition given in Table 1 to produce fumed silica. After the deacidification step, the resulting fumed silica was collected. Into a quartz-glass fluidized bed having an inside diameter of 15 cm, 250 g of this fumed silica was introduced. From the lower portion, air preheated to a temperature substantially the same as that of the fumed silica was introduced at 5 Nm³/h for 30 minutes, and then 225 g out of the introduced silica was extracted from the upper portion of the tube to be classified. This classification step was repeated twice, and 203 g of fumed silica was obtained. The obtained fumed silica was compressed by the deaeration press to adjust the bulk density to 0.05 g/cm³, whereby fumed silica powder was obtained. Table 1 collectively shows the specific surface area, the contents of impurities, the residual amount on a sieve measured by wet sieving using an electroformed sieve having a perforation size of 5 µm, the scratch density, and the polishing rate of the obtained fumed silica.

### Example 5

The same tetrachlorosilane as that used in Example 1 was used as halogenated silane, and subjected to flame hydrolysis reaction under the corresponding production condition given in Table 1 to produce fumed silica. After the separation and collection step, the resulting fumed silica was collected. Into a quartz-glass fluidized bed having an inside diameter of 15 cm, 250 g of this fumed silica was introduced. From the lower portion, air preheated to a temperature substantially the same as that of the fumed silica was introduced at 10 Nm³/h for 30 minutes, and then 225 g out of the introduced silica was extracted from the upper portion of the tube to be classified. The fumed silica after the classification was subjected to the deacidification step, and was collected again. Fumed silica collected from the deacidification step, 225 g, was introduced into the fluidized bed again, was fluidized under the above-described conditions, and then 203 g was extracted from the upper portion of the tube to be classified. The fumed silica obtained after the classification was compressed by the deaeration press to adjust the bulk density to 0.05 g/cm³, whereby fumed silica powder was obtained. Table 1 collectively shows the specific surface area, the contents of impurities, the residual amount on a sieve measured by wet sieving using an electroformed sieve having a perforation size of 5 µm, the scratch density, and the polishing rate of the obtained fumed silica powder.

### Comparative Example 1

The same tetrachlorosilane as that used in Example 1 was used as halogenated silane, and subjected to flame hydrolysis reaction under the corresponding production condition given in Table 1 to produce fumed silica. After the deacidification step, the resulting fumed silica was compressed by the deaeration press to adjust the bulk density to 0.05 g/cm³, whereby fumed silica powder was obtained. Table 1 collectively shows the specific surface area, the contents of impurities, the residual amount on a sieve measured by wet sieving using an electroformed sieve having a perforation size of 5 µm, the scratch density, and the polishing rate of the obtained fumed silica.

### Comparative Examples 2 and 3

The same tetrachlorosilane as that used in Example 1 was used as halogenated silane, and subjected to flame hydrolysis reaction under each corresponding production condition given in Table 1 to produce fumed silica. After the separation and collection step, the resulting fumed silica was collected. In a quartz-glass fluidized bed having an inside diameter of 15 cm, 250 g of this fumed silica was introduced. From the lower portion, air preheated to a temperature substantially the same as that of the fumed silica was introduced at 5 Nm³/h for 30 minutes, and then 225 g out of the introduced silica was extracted from the upper portion of the tube to be classified. The fumed silica after the classification was subjected to the deacidification step, and was collected again. Fumed silica collected from the deacidification step, 225 g, was introduced into the fluidized bed again, was fluidized under the above-described conditions, and then 203 g was extracted from the tube upper portion to be classified. The fumed silica obtained after being classified was compressed by the deaeration press to adjust the bulk density to 0.05 g/cm³, whereby fumed silica powder was obtained. Table 1 collectively shows the specific surface area, the contents of impurities, the residual amount on a sieve measured by wet sieving using an electroformed sieve having a perforation size of 5 µm, the scratch density, and the polishing rate of each obtained fumed silica powder.

### Comparative Example 4

The same tetrachlorosilane as that used in Example 1 was used as halogenated silane, and subjected to flame hydrolysis reaction under the corresponding production condition given in Table 1 to produce fumed silica. After the deacidification step, the resulting fumed silica was compressed by the deaeration press to adjust the bulk density to 0.05 g/cm³, whereby fumed silica was obtained. In a quartz-glass fluidized bed having an inside diameter of 15 cm, 250 g of this fumed silica was introduced. From the lower portion, air preheated to a temperature substantially the same as that of the fumed silica was introduced at 5 Nm³/h for 30 minutes, and then 225 g out of the introduced silica was extracted from the upper portion of the tube to be classified. This classification step was repeated twice, and 203 g of fumed silica was obtained. Table 1 collectively shows the specific surface area, the contents of impurities, the residual amount on a sieve measured by wet sieving using an electroformed sieve having a perforation size of 5 µm, the scratch density, and the polishing rate of the obtained fumed silica powder.

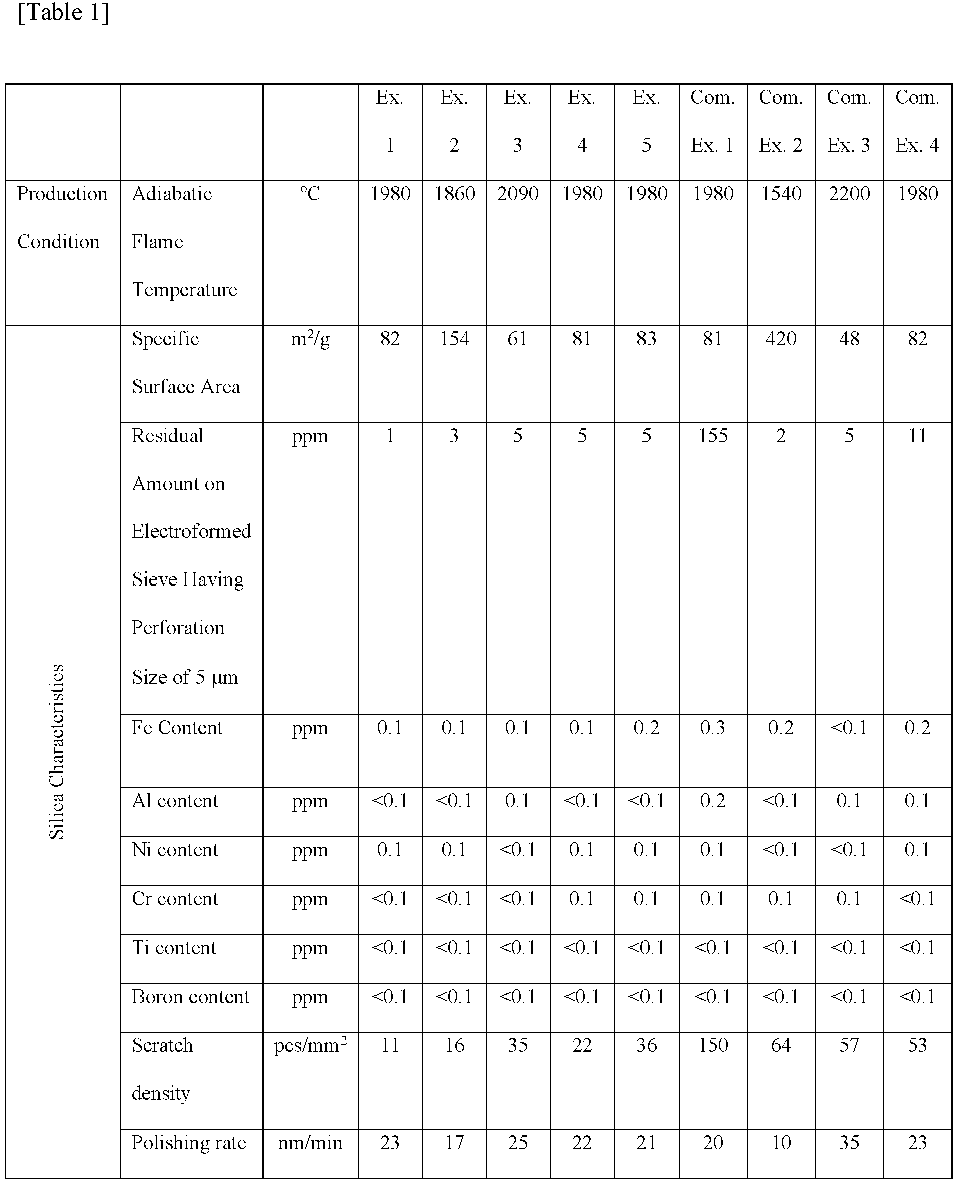

## Claims

1. Fumed silica, wherein
the fumed silica is produced using tetrachlorosilane by flame hydrolysis, and has a BET specific surface area of 57 m²/g or larger and 400 m²/g or smaller, and
when a dispersion liquid, which is prepared by ultrasonically dispersing 6.25 mass% of the fumed silica in water at an oscillation frequency of 20 kHz and an amplitude of 15 µm to 25 µm for three minutes, is subjected to wet sieving using an electroformed sieve having a perforation size of 5 µm, a residual amount of the fumed silica on the sieve is 5 ppm or lower.

2. The fumed silica of claim 1, wherein
the fumed silica contains 0.3 ppm or lower of Fe, 0.3 ppm or lower of Al, 0.1 ppm or lower of Ni, 0.1 ppm or lower of Cr, 0.1 ppm or lower of Ti, and 0.1 ppm or lower of boron.

3. Fumed silica for CMP, comprising the fumed silica of claim 1 or 2.

4. A method for producing the fumed silica of claim 1, the method comprising:
a reaction step of feeding silane gas as a raw material into a reactor and burning or hydrolyzing the silane gas in flame to form fumed silica;
a cooling step of cooling the fumed silica and a reactant gas;
a separation and collection step of separating and collecting the fumed silica from the reactant gas; and
a compression step of increasing a bulk density of the fumed silica; wherein
the method further comprises a dry classification step of removing the fumed silica having a particle diameter of 5 µm or larger before the compression step.

## Patentansprüche

1. Pyrogenes Siliciumdioxid, wobei
das pyrogene Siliciumdioxid unter Verwendung von Tetrachlorsilan durch Flammenhydrolyse hergestellt wird und eine spezifische BET-Oberfläche von 57 m²/g oder größer und 400 m²/g oder kleiner aufweist, und
wenn eine Dispersionsflüssigkeit, die durch Ultraschalldispergieren von 6,25 Masse-% des pyrogenen Siliciumdioxids in Wasser bei einer Schwingungsfrequenz von 20 kHz und einer Amplitude von 15 µm bis 25 µm über drei Minuten hergestellt wird, Nasssieben unter Verwendung eines elektrogeformten Siebs, das eine Perforationsgröße von 5 µm aufweist, unterzogen wird, eine Restmenge des pyrogenen Siliciumdioxids auf dem Sieb 5 ppm oder weniger beträgt.

2. Pyrogenes Siliciumdioxid nach Anspruch 1, wobei
das pyrogene Siliciumdioxid 0,3 ppm oder weniger Fe, 0,3 ppm oder weniger Al, 0,1 ppm oder weniger Ni, 0,1 ppm oder weniger Cr, 0,1 ppm oder weniger Ti und 0,1 ppm oder weniger Bor enthält.

3. Pyrogenes Siliciumdioxid für CMP, das das pyrogene Siliciumdioxid nach Anspruch 1 oder 2 umfasst.

4. Verfahren zum Herstellen des pyrogenen Siliciumdioxids nach Anspruch 1, wobei das Verfahren umfasst:
einen Reaktionsschritt des Einspeisens von Silangas als Rohstoff in einen Reaktor und Verbrennens oder Hydrolysierens des Silangases in Flamme, um pyrogenes Siliciumdioxid zu bilden;
einen Kühlschritt des Abkühlens des pyrogenen Siliciumdioxids und eines Reaktantengases;
einen Trenn- und Sammelschritt des Trennens und Sammelns des pyrogenen Siliciumdioxids aus dem Reaktantengas; und
einen Kompressionsschritt des Erhöhens einer Schüttdichte des pyrogenen Siliciumdioxids; wobei
das Verfahren weiter einen Trockenklassifizierungsschritt des Entfernens des pyrogenen Siliciumdioxids, das einen Partikeldurchmesser von 5 µm oder größer aufweist, vor dem Kompressionsschritt umfasst.

## Revendications

1. Silice pyrogénée, dans laquelle
la silice pyrogénée est produite en utilisant du tétrachlorosilane par hydrolyse à la flamme, et a une surface spécifique BET supérieure ou égale à 57 m²/g et inférieure ou égale à 400 m²/g, et
lorsqu'un liquide de dispersion, qui est préparé par dispersion par ultrasons de 6,25% en masse de la silice pyrogénée dans l'eau à une fréquence d'oscillation de 20 kHz et une amplitude allant de 15 µm à 25 µm pendant trois minutes, est soumis à un tamisage humide en utilisant un tamis électroformé ayant une taille de perforation de 5 µm, une quantité résiduelle de la silice pyrogénée sur le tamis est inférieure ou égale à 5 ppm.

2. Silice pyrogénée de la revendication 1, dans laquelle
la silice pyrogénée contient 0,3 ppm ou moins de Fe, 0,3 ppm ou moins d'Al, 0,1 ppm ou moins de Ni, 0,1 ppm ou moins de Cr, 0,1 ppm ou moins de Ti, et 0,1 ppm ou moins de bore.

3. Silice pyrogénée pour CMP, comprenant la silice pyrogénée de la revendication 1 ou 2.

4. Procédé de production de la silice pyrogénée de la revendication 1, le procédé comprenant :
une étape de réaction consistant à introduire du gaz silane en tant que matière première dans un réacteur et à brûler ou hydrolyser le gaz silane à la flamme pour former la silice pyrogénée ;
une étape de refroidissement consistant à refroidir la silice pyrogénée et un gaz réactif ;
une étape de séparation et de collecte consistant à séparer et à collecter la silice pyrogénée du gaz réactif ; et
une étape de compression consistant à augmenter la densité apparente de la silice pyrogénée ; où
le procédé comprend en outre une étape de classification à sec consistant à retirer la silice pyrogénée ayant un diamètre de particules supérieur ou égal à 5 µm avant l'étape de compression.
